Europäisches Patentamt

European Patent Office

Office européen des brevets

(19)

(11) Veröffentlichungsnummer : **0 369 102 B1**

# (12) EUROPÄISCHE PATENTSCHRIFT

(45) Veröffentlichungstag der Patentschrift :
**02.11.94 Patentblatt 94/44**

(51) Int. Cl.$^5$ : **H03C 1/00,** H03B 21/00,
H04H 5/00

(21) Anmeldenummer : **89108838.7**

(22) Anmeldetag : **17.05.89**

(54) **Modulationsverfahren und Anordnung zum Durchführen des Verfahrens.**

(30) Priorität : **17.11.88 DE 3838872**

(43) Veröffentlichungstag der Anmeldung :
**23.05.90 Patentblatt 90/21**

(45) Bekanntmachung des Hinweises auf die
Patenterteilung :
**02.11.94 Patentblatt 94/44**

(84) Benannte Vertragsstaaten :
**CH DE FR GB IT LI**

(56) Entgegenhaltungen :
**EP-A- 0 077 091
EP-A- 0 146 195
EP-A- 0 260 378
US-A- 4 194 161**

(73) Patentinhaber : **TELEFUNKEN Sendertechnik
GmbH
Sickingenstrasse 20-28
D-10553 Berlin (DE)**

(72) Erfinder : **Tröger, Peter, Dipl.-Ing.
Alt-Mariendorf 56a
D-1000 Berlin 42 (DE)**

(74) Vertreter : **Schulze, Harald Rudolf, Dipl.-Ing.
Deutsche Aerospace AG,
Patentabteilung,
Sedanstrasse 10
D-89077 Ulm (DE)**

## Beschreibung

Die Erfindung bezieht sich auf ein Modulationsverfahren gemäß Oberbegriff des Patentanspruchs 1 sowie auf eine Anordnung zum Durchführen des Verfahrens. Ein solches Verfahren ist beispielsweise aus der DE 36 31 818 A1 bekannt.

In der DE 36 31 818 A1 wird ein Coder beschrieben, der zur Anwendung des bekannten Modulationsverfahrens geeignet ist. Bei diesem Coder wird das modulierende Signal der Frequenz $f_1$ dem Eingang des Coders zugeführt und gelangt von dort an die Eingänge zweier Mischer. Eine Trägerfrequenz $f_T$ wird in einem HF-Generator erzeugt und dem ersten Mischer direkt und dem zweiten Mischer über einen Phasenschieber um 60° phasenverschoben zugeführt. Die Ausgangssignale der beiden Mischer werden in einem Addierer vereinigt. Am Ausgang des Addierers kann die mit der Frequenz $f_1$ modulierte Trägerfrequenz $f_T$ abgenommen werden. Ein nachgeschalteter Tiefpaß dient zur Unterdrückung unerwünschter Oberwellen.

Infolge der Anwendung zweier um 60° versetzter Trägerfrequenzen für die beiden Mischer und der Addition der Ausgangssignale der Mischer kompensieren sich die ersten bis dritten Oberwellen. Die Kompensation der Oberwellen bei dem bekannten Verfahrn kann wie folgt erklärt werden:

Für die Mischprodukte am Ausgang eines Mischers gilt:

$$f_M = (f_T \pm f_1) + (2 \cdot f_T \pm f_1) + (3 \cdot f_T \pm f_1) + (4 \cdot f_T \pm f_1) + (5 \cdot f_T \pm f_1 + \ldots (n \cdot f_T \pm f_1)$$

mit n = ganze Zahl > 1

Bei Symmetrie der Trägerfrequenz $f_T$ (positive und negative Halbwellen haben den gleichen zeitlichen Verlauf) heben sich alle Mischprodukte mit geradzahligem n auf. Da dem zweiten Mischer eine um 60° phasenverschobene Trägerfrequenz zugeführt wird, liegen am Eingang des Addiergliedes mit n = 3 die sich bei der Addition auslöschenden Mischfrequenzen $+(3 \cdot f_T \pm f_1)$ und $-(3 \cdot f_T \pm f_1)$.

Besonders einfach im Aufbau wird der Coder bei der Verwendung des sogenannten Schalterverfahrens, das insbesondere bei der Aufbereitung eines Stereosignals beim Rundfunk angewendet wird. Bei diesem wird die modulierende Frequenz $f_1$ im Takt der als Rechtecksignal gewählten Trägerfrequenz $f_T$ durch elektronische Schalter getaktet. Das Tastverhältnis soll wegen der Symmetrie möglichst genau 2:1 sein, damit sich im Mischprodukt Glieder mit ganzzahligem n kompensieren.

Aus der EP-A1-0077091 ist eine Mischerschaltung für den Einsatz in Stereocodern und PLL-Schaltungen bekannt, in der ebenfalls bei der Addition einzelner, speziell gewichteter Mischersignale unerwünschte Oberwellen im Ausgangssignal unterdrückbar sind. Dazu werden in dieser bekannten Schaltung zeitlich versetzte Impulse erzeugt und diese mit Pulsformerschaltungen (resphaping cicuit) in zeitlich versetzte Pulse definierter Länge umgewandelt. Die Anzahl und die Länge der Pulse ist abhängig von einem Grad N, mit dem festgelegt ist, wieviele Oberwellen (N-1) unterdrückt werden. Wenn die Schaltung z. B. für N=7 ausgelegt ist, dann werden die Oberwellen zwei bis sechs unterdrückt. Dazu müssen sieben Pulse generiert werden, von denen jeder eine von sieben parallelen Mischerstufen ansteuert, deren Ausgangssignale mit unterschiedlicher Wichtung zu einem Summenausgangssignal addiert werden. Die einzelnen Pulse haben bei dieser Schaltungsauslegung eine Pulslänge von To/6. Die zeitliche Versetzung der einzelnen Pulse ist ebenfalls vom Grad N abhängig.

Die Aufgabe der Erfindung besteht darin, ein Modulationsverfahren der eingangs genannten Art zu schaffen, mit dem die Oberwellen zwei bis sechs (und alle weiteren geradzahligen Oberwellen) des modulierten Trägersignales bei geringem Schaltungsaufwand kompensiert werden.

Die Lösung der Aufgabe ist im Anspruch 1 beschrieben. Der Anspruch 3 gibt eine Anordnung zum Durchführen des erfindungsgemäßen Verfahrens an.

Die Erfindung hat den Vorteil, daß die Unterdrückung der unerwünschten Oberwellen zwei bis sechs in einer Schaltung mit nur drei parallelen Mischerstufen realisierbar ist und daß zur Ansteuerung der Mischerstufen symmetrische Pulse mit einer Länge von To/2 verwendbar sind.

Im folgenden wird die Erfindung anhand der Figuren näher erläutert. Es zeigen

Fig. 1      Zeitdiagramme von drei erfindungsgemäß gegeneinander phasenversetzten Trägersignalen;

Fig. 2      ein Blockschaltbild einer vorteilhaften Ausführungsform einer bevorzugten erfindungsgemäßen Anordnung zum Durchführen des erfindungsgemäßen Modulationsverfahrens;

FIG. 3      ein Schaltbild einer vorteilhaften Ausführungsform einer bevorzugten erfindungsgemäßen Anordnung gemäß FIG. 2 zur Erzeugung eines MPX-Signals für den Stereorundfunk,

FIG. 4      ein Schaltbild einer vorteilhaften Ausführungsform der Trägersignalerzeugung für die erfindungsgemäße Anordnung gemäß FIG. 3;

FIG. 5      Zeitdiagramme von Signalfolgen an den Ein- und Ausgängen einzelner Baugruppen des Schaltbildes gemäß FIG. 4.

Beim erfindungsgemäßen Verfahren wird das Modulationssignal in drei Mischern im Takt eines Trägersignals zum Ausgang des Modulators durchgeschaltet. Die Trägersignale für die einzelnen Mischer sind dabei gegeneinander phasenverschoben. Die Phasenverschiebung ist starr. In einer bevorzugten Ausführungsform

2

EP 0 369 102 B1

wird die Mischung unter Verwendung des Schalter-Verfahrens durchgeführt, bei dem die Trägersignale als rechteckförmige Schaltspannungen den einzelnen Mischern zugeführt werden, die ihrerseits in der einfachsten Form jeweils als elektronischer Schalter realisiert sind, welcher durch das zugehörige Trägersignal ein- und ausgeschaltet wird und dadurch das Modulationssignal im Takt des Trägersignals zum Ausgang des Modulators durchschaltet.

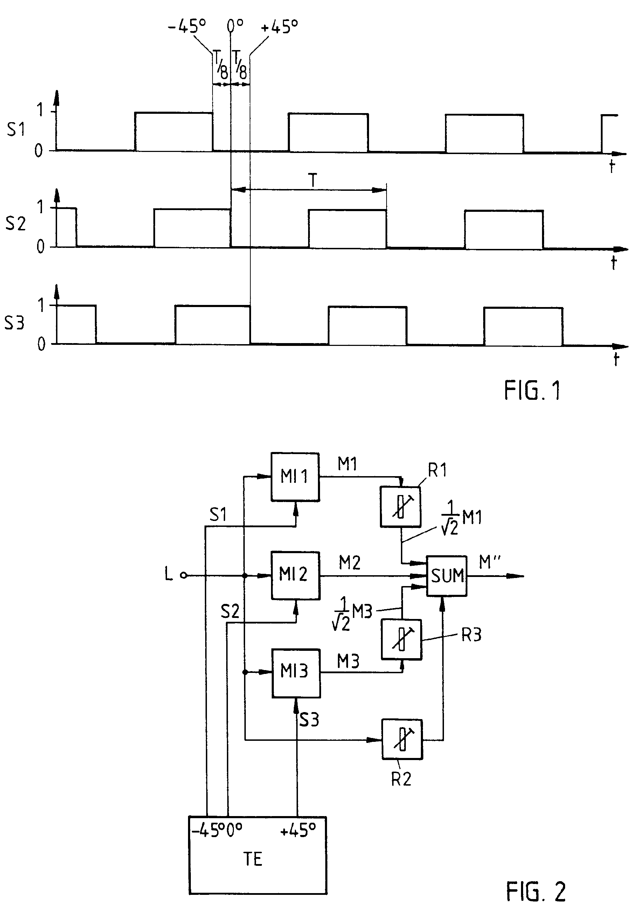

Definiert man, wie in FIG. 1 und 2 gezeigt, die Phasenlage der Schaltspannung S2 des Mischers MI2 mit 0°, so beträgt die Phasenverschiebung der Schaltspannung S1 des Mischers MI1 relativ zur Schaltspannung S2 -45° und die der Schaltspannung S3 des Mischers MI3 +45°. Die so entstehenden durchgeschalteten Mischsignale M1 bis M3 werden in einem Additionsglied SUM addiert, wobei die Mischsignale M1 bzw. M3 des Mischers MI1 bzw. MI3 zuvor jeweils mittels eines Widerstandes R1 bzw. R3 mit dem Faktor $\frac{1}{\sqrt{2}}$ gewichtet werden. Am Ausgang des Additionsgliedes SUM erscheint das mit dem Modulationssignal L modulierte Trägersignal M'', wobei, wie weiter unten näher erläutert wird, das Modulationssignal L zusätzlich über einen den Mischern MI1 bis MI3 parallel geschalteten Widerstand R2 dem Additionsglied SUM zugeführt ist.

Eine Fourier-Zerlegung der einzelnen Schaltspannungen S1 bis S3 der Mischer MI1 bis MI3 in FIG. 1 ergibt, daß jeweils nur die ungeradzahligen Harmonischen der Trägergrundfrequenz vorhanden sind.

$$S1(t) = 0,5 + \frac{2}{\pi}\left(\sin(\omega t - 45°) + \frac{1}{3}\sin 3(\omega t - 45°)\right.$$
$$\left. + \frac{1}{5}\sin 5(\omega t - 45°) + \frac{1}{7}\sin 7(\omega t - 45°) + ...\right) \qquad (1a)$$

$$S2(t) = 0,5 + \frac{2}{\pi}\left(\sin\omega t + \frac{1}{3}\sin 3\omega t + \frac{1}{5}\sin 5\omega t\right.$$
$$\left. + \frac{1}{7}\sin 7\omega t + ...\right) \qquad (1b)$$

$$S3(t) = 0,5 + \frac{2}{\pi}\left(\sin(\omega t + 45°) + \frac{1}{3}\sin 3(\omega t + 45°)\right.$$
$$\left. + \frac{1}{5}\sin 5(\omega t + 45°) + \frac{1}{7}\sin 7(\omega t + 45°) + ...\right) \qquad (1c)$$

wobei $\omega = 2\pi f_T$ mit $f_T$ = Trägerfrequenz ist.

Die Ausgangssignale M1 bis M3 der einzelnen Mischer MI1 bis MI3 werden gebildet durch:
$$MX = L \cdot SX \qquad (2)$$
mit X = 1, 2, 3
woraus folgt:

$$M1 = L + \frac{4}{\pi} L \left(\sin(\omega t - 45°) + \frac{1}{3}\sin 3(\omega t - 45°)\right.$$
$$\left. + \frac{1}{5}\sin 5(\omega t - 45°) + \frac{1}{7}\sin 7(\omega t - 45°) + ...\right) \qquad (3a)$$

$$M2 = L + \frac{4}{\pi} L \left(\sin\omega t + \frac{1}{3}\sin 3\omega t + \frac{1}{5}\sin 5\omega t + \frac{1}{7}\sin 7\omega t + ...\right) \qquad (3b)$$

3

$$M3 = L + \frac{4}{\pi} L \left( \sin(\omega t + 45°) + \frac{1}{3}\sin 3(\omega t + 45°) \right.$$
$$\left. + \frac{1}{5}\sin 5(\omega t + 45°) + \frac{1}{7}\sin 7(\omega t + 45°) + ... \right) \qquad \left.\right\} \qquad (3c)$$

Für das Summensignal ergibt sich zunächst:

$$M = \frac{1}{\sqrt{2}} M1 + M2 + \frac{1}{\sqrt{2}} M3 \qquad (4)$$

Mit Hilfe der Additionstheoreme kann gezeigt werden, daß gilt:

$$M = L \cdot (1 + \sqrt{2}) + \frac{4}{\pi} L \left(2\sin\omega t + \frac{2}{7}\sin 7\omega t + \frac{2}{9}\sin 9\omega t + \frac{2}{15}\sin 15\omega t + \frac{2}{17}\sin 17\omega t + \frac{2}{23}\sin 23\omega t + ...\right) \qquad (5)$$

woraus folgt:

$$M' = \frac{M}{(1 + \sqrt{2})} = L + \frac{8}{\pi(1 + \sqrt{2})} L \left(\sin\omega t + \frac{1}{7}\sin 7\omega t + \frac{1}{9}\sin 9\omega t + ...\right) \qquad (6)$$

Wie Gleichung (6) zeigt, unterscheidet sich das geträgerte Signal somit um den Faktor $\dfrac{8}{\pi(1 + \sqrt{2})}$. Bei diesem Verfahren ist daher ein Angleich der Amplituden erforderlich. Dieser wird durch das Parallelschalten des Widerstandes R2 zu den Mischern MI1 bis MI3 erreicht, woraus folgt:

$$M'' = L + L \left(\sin\omega t + \frac{1}{7}\sin 7\omega t + \frac{1}{9}\sin 9\omega t + ...\right) \qquad (7)$$

Ein auf diese Weise erzeugtes moduliertes Trägersignal enthält somit bis zur 6. Harmonischen (n = 7) keine Oberwellen. Dieses ist beispielsweise für die Erzeugung eines MPX-Signals sehr günstig, da an einen Tiefpaß zum Wegschneiden der noch vorhandenen Oberwellen keine so hohen Ansprüche gestellt werden müssen wie bei dem bekannten Verfahren, das nur bis zur 4. Harmonischen (n = 5) keine Oberwellen enthält. Dadurch kann mit dem erfindungsgemäßen Verfahren eine höhere Übersprechdämpfung bei hohen NF-Frequenzen erreicht werden.

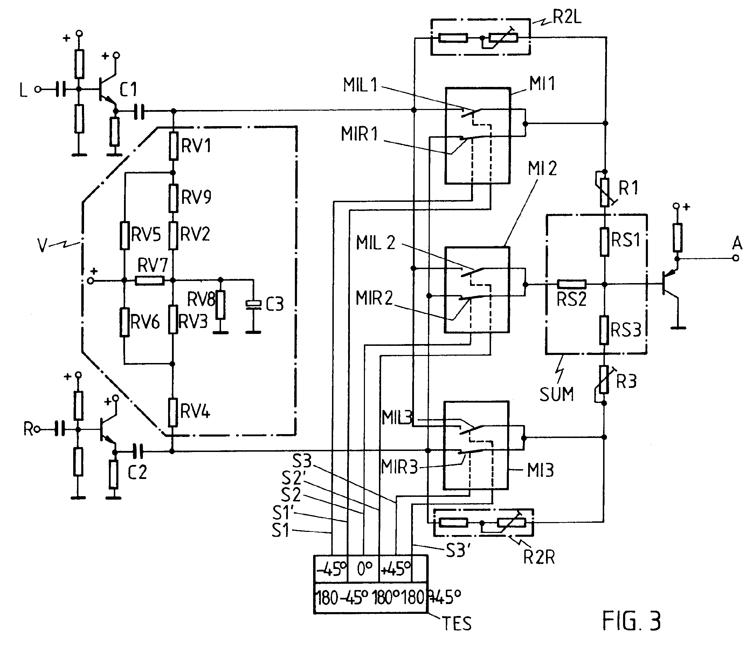

FIG. 3 beschreibt eine Modulatorschaltung auf der Basis der erfindungsgemäßen Modulatorschaltung gemäß FIG. 2 für die Erzeugung eines MPX-Signals für den Stereorundfunk.

Die Bauteile RV1 bis RV9 und C3 bilden eine Vorspannung V für die über C1 und C2 eingekoppelten Modulationssignale L (linker Kanal) und R (rechter Kanal). Mit RV9 kann die Hilfsträgerunterdrückung abgeglichen werden. Über R1, R3 und RS1 bis RS3 geschieht die Addition der drei einzelnen Mischerausgangssignale. Mit R1 und R3 wird jeweils der Faktor $\frac{1}{\sqrt{2}}$ abgeglichen. R2L und R2R dienen für die beschriebene Amplitudenangleichung. Die Mischer sind mit MI1 bis MI3 bezeichnet und setzen sich jeweils aus zwei Teilmischern MIL1, MIR1; MIL2, MIR2; MIL3, MIR3 zusammen. Als einzelne Teilmischer können jeweils Analogschalter (z.B. CD 4066) verwendet werden. Die beiden Schalter MIL1, MIR1 bzw. MIL2, MIR2 bzw. MIL3, MIR3 eines Mischers MI1 bzw. MI2 bzw. MI3 werden jeweils im Gegentakt geschaltet (z.B. Q- und $\overline{Q}$-Ausgänge eines Flip-Flops), wodurch abwechselnd das linke und rechte Modulationssignal L bzw. R zum Ausgang A des Modulators durchgeschaltet wird.

Die phasenversetzten Trägersignale werden in einer Trägersignalerzeugung TES gebildet, und zwar in zwei Gruppen: die erste Gruppe umfaßt die drei Trägersignale mit Phasenverschiebungen -45°, 0° und +45°, die zweite Gruppe die zur ersten Gruppe im Gegentakt arbeitenden Trägersignale mit Phasenverschiebungen von 180° - 45°, 180° und 180° + 45°.

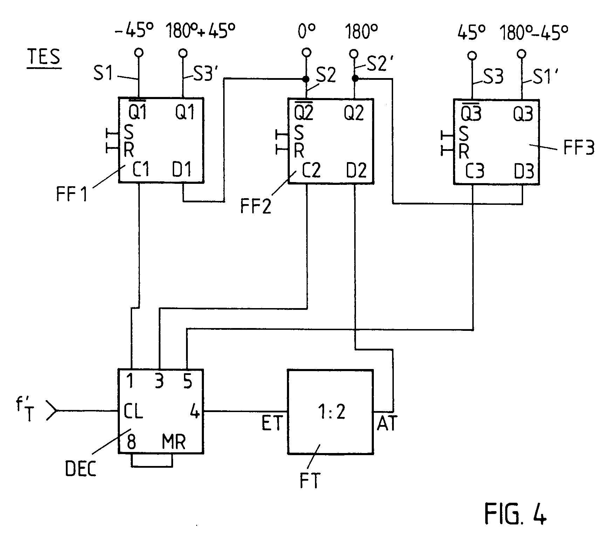

FIG. 4 zeigt, wie die phasenverschobenen Trägersignale als Rechtecksignale erzeugt werden können. Die Schaltung TES synchronisiert sich selbst und benötigt keinen besonderen Startimpuls oder eine besondere Ausgangslage.

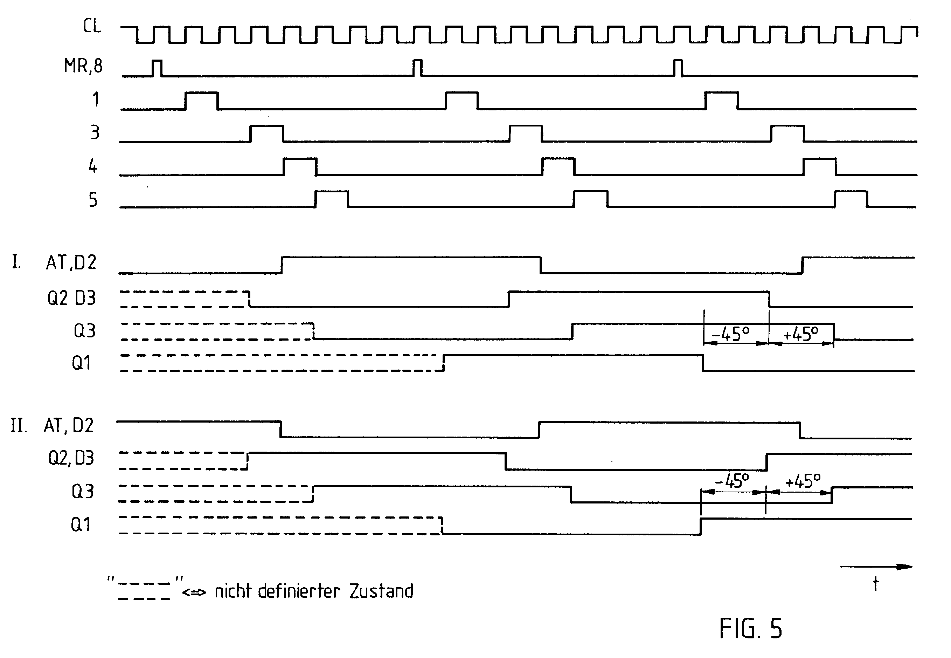

An den Eingang CL eines Dezimaldecoders DEC (z.B. CD 4017), der durch Verbinden seiner Anschlüsse 9 und 15 (Verbindung des Decoderausganges "8" mit dem RESET-Eingang MR) auf eine 8er-Periode umgeschaltet ist, wird eine Taktfrequenz $f_T$ angelegt, die 16 mal höher ist als die erforderliche Schaltfrequenz $f_T$, also die Frequenz der Trägersignale S1 bis S3 bzw. S1' bis S3'. Die Synchronisation geht von einem 1:2-Frequenzteiler FT (z.B. CD 4520) aus. Der Ausgang AT des Teilers FT ist hierzu mit dem Dateneingang D2 des Flip-Flops FF2 verbunden. Unabhängig von seinem Ruhezustand übernimmt er die ankommenden Daten des Teilers FT. Die Flip-Flops FF1 und FF3, die wie das Flip-Flop FF2 mit ihren Takteingängen C1 bis C3 mit den Ausgängen 1, 3 bzw. 5 des Dezimaldecoders DEC verbunden sind, übernehmen ebenfalls unabhängig von ihrem Ruhezustand die Ausgangsdaten vom Flip-Flop FF2, so daß die Phasenverschiebungen immer gleich sind (siehe FIG. 5). Die SET- und RESET-Eingänge der drei Flip-Flops FF1 bis FF3 liegen dabei an Masse. Die Zeitverschiebung der phasenvershobenen Takte beträgt zwei Periodendauern von beispielsweise $f_T' = 608$ kHz. Diese Zeitverschiebung bedeutet jeweils eine Phasenverschiebung von +45° oder -45°, bezogen auf die entsprechende Frequenz $f_T = 38$ kHz des Trägersignals.

Es versteht sich, daß die Erfindung mit fachmännischem Können und Wissen aus- und weitergebildet bzw. an die verschiedenen Anwendungen angepaßt werden kann, ohne daß dies hier an dieser Stelle näher erläutert werden müßte.

So sind beispielsweise auch andere Schaltungen denkbar, mit denen auf der Grundlage des erfindungsgemäßen Verfahrens ein MPX-Signal für den Stereorundfunk erzeugt werden kann.

Ein wesentlicher Vorteil der Erfindung besteht darin, daß das modulierte Trägersignal erst die sechste Oberwelle $(7f_T \pm f_1)$ enthält und somit die Anforderungen an ein dem Modulator nachgeschaltetes Tiefpaßfilter zur Ausfilterung der Oberwellen außerordentlich gering sind, so daß beispielsweise ein preisgünstiger LC-Tiefpaßfilter genügt.

**Patentansprüche**

1. Modulationsverfahren, bei welchem zunächst gegeneinander phasenversetzte Trägersignale erzeugt werden, anschließend diese phasenversetzten Trägersignale (S1 bis S3) getrennt voneinander mit einem Modulationssignal (L) gemischt werden und schließlich die Mischprodukte zur Gewinnung des modulierten Trägersignales gewichtet und addiert werden, dadurch gekennzeichnet, daß drei gegeneinander phasenversetzte Trägersignale (S1 bis S3) erzeugt werden, daß die Phase des ersten Trägersignales (S1) um -45°, zumindest jedoch annähernd -45°, gegenüber der mit 0° definierten Phase des zweiten Trägersignales (S2) versetzt wird und die Phase des dritten Trägersignales (S3) um +45°, zumindest jedoch um annähernd +45°, gegenüber der Phase des zweiten Trägersignales (S2) versetzt wird, daß die durch die Mischung des ersten Trägersignales (S1) mit dem Modulationssignal (L) erzeugten ersten Mischsignale (M1) und die durch die Mischung des dritten Trägersignales (S3) mit dem Modulationssignal (L) erzeugten dritten Mischsignale (M3) jeweils mit einem ersten Faktor $1/\sqrt{2}$ gewichtet werden und daß der Summe der Mischsignale (M1 bis M3) das mit einem zweiten Faktor gewichtete Modulationssignal (L) aufaddiert wird, derart daß die geträgerten Komponenten der Summe der Mischsignale (M1 bis M3) mit einem Faktor $\pi/8$ $(1 + \sqrt{2})$ beaufschlagt sind.

2. Modulationsverfahren nach Anspruch 1, dadurch gekennzeichnet, daß die Mischung der Trägersingale (S1 bis S3) mit dem Modulationssignal (L) unter Verwendung des Schalterverfahrens erfolgt.

3. Anordnung zum Durchführen des Verfahrens nach einem der Ansprüche 1 bis 3, dadurch gekennzeichnet,
   - daß zur Mischung der phasenversetzten Trägersignale (S1 bis S3) mit dem Modulationssignal (L) jeweils ein Mischer (MI1 bis MI3) und zur Addition der Mischsignale (M1 bis M3) ein Additionsglied (SUM) vorgesehen ist;
   - daß der mit dem ersten Trägersignal (S1) gespeiste erste Mischer (MI1) und der mit dem dritten Trägersingal (S3) gespeiste dritte Mischer (MI3) jeweils über einen die ersten und dritten Mischsignale (M1; M3) mit dem ersten Faktor $1/\sqrt{2}$ wichtenden Widerstand (R1; R3) und der dem zweiten Trägersignal (2) gespeiste zweite Mischer (MI2) direkt mit dem Additionsglied (SUM) verbunden ist;
   - daß das Modulationssignal (L) über einen den Mischern (MI1 bis MI3) parallel geschalteten wichtenden Widerstand (R2) dem Additionsglied (SUM) zugeführt ist und daß dieser Widerstand (R2) so bemessen ist, daß die geträgerten Komponenten der Summe der Mischsignale (M1 bis M3) mit dem Faktor $\pi/8$ $(1 + \sqrt{2})$ beaufschlagt sind.

4. Anordnung nach Anspruch 3 zur Erzeugung eines MPX-Signals für Stereorundfunk mit zwei unterschiedlichen Modulationssignalen, dadurch gekennzeichnet,
   - daß die drei Mischer (MI1 bis MI3) jeweils in einen ersten und einen zweiten Teilmischer (MIL1, MIR1; MIL2, MIR2; MIL3, MIR3) aufgespalten sind;
   - daß die ersten Teilmischer (MIL1 bis MIL3) das erste Modulationssignal (L) mit einer ersten Gruppe von um -45°, 0° und +45° gegeneinander phasenversetzten Trägersignalen (S1 bis S3) mischen und die zweiten Teilmischer (MIR1 bis MIR3) das zweite Modulationssignal (R) mit einer im Gegentakt zur ersten Gruppe von Trägersignalen (S1 bis S3) arbeitenden zweiten Gruppe von um 180°-45°, 180° und 180°+45° gegeneinander phasenversetzten Trägersignalen (S1′ bis S3′) mischen.

5. Anordnung nach Anspruch 4, dadurch gekennzeichnet, daß zur Erzeugung der beiden Gruppen von phasenversetzten Trägersignalen (S1 bis S3; S1' bis S3')

- ein Dezimaldecoder (DEC) mit seinem Ausgang 1 mit dem Takteinang CL eines ersten Flip-Flops (FF1), mit seinem Ausgang 3 mit dem Takteingang C2 eines zweiten Flip-Flops (FF2), mit seinem Ausgang 4 über einen 1:2-Frequenzteiler (FT) mit dem Dateneingang D2 des zweiten Flip-Flops (FF2) und mit seinem Ausgang 5 mit dem Takteingang C3 eines dritten Flip-Flops (FF3) verbunden ist;
- das zweite Flip-Flop (FF2) mit seinem Ausgang $\overline{Q2}$ mit dem Dateneingang D1 des ersten Flip-Flops (FF1) und mit seinem Ausgang Q2 mit dem Dateneingang D3 des dritten Flip-Flops (FF3) verbunden ist;
- beim Dezimaldecoder (DEC) der Ausgang 8 mit dem RESET-Eingang MR direkt verbunden ist und bei den drei Flip-Flops (FF1 bis FF3) die SET-und RESET-Eingänge an Masse angeschlossen sind;
- daß am Takteingang CL des Dezimaldecoders (DEC) ein Taktsignal $f'_T$ mit der n-fachen Frequenz der an den Ausgängen $\overline{Q1}$, $\overline{Q2}$, $\overline{Q3}$ bzw. Q1, Q2, Q3 der drei Flip-Flops (FF1 bis FF3) abgegebenen und um -45°, 0° und +45° bzw. 180°+45°, 180° und 180°-45° gegeneinander phasenversetzten Trägersignalen (S1 bis S3; S3' bis S1') anliegt.

## Claims

1. Modulation process, in which carrier signals, which are displaced in phase one relative to the other, are generated initially, these phase-displaced carrier signals (S1 to S3) are subsequently mixed separately with a modulation signal (L) and the mixture products are finally weighted and added to obtain the modulated carrier signal, characterised thereby, that three carrier signals (S1 to S3), which are displaced in phase one relative to the other, are generated, that the phase of the first carrier signal (S1) is displaced by -45°, at least however approximately -45°, relative to the phase, which is defined as 0°, of the second carrier signal (S2) and the phase of the third carrier signal (S3) is displaced by +45°, at least however approximately +45°, relative to the phase of the second carrier signal (S2), that the first mixture signals (M1) produced by the mixing of the first carrier signal (S1) with the modulation signal (L) and the third mixture signals (M3) produced by the mixing of the third carrier signal (S3) with the modulation signal (L) are each weighted by a first factor $1/\sqrt{2}$ and that the modulation signal (L) weighted by a second factor is added to the sum of the mixture signals (M1 to M3) in such a manner that the carrier-borne components of the sum of the mixture signals (M1 to M3) are acted on by a factor $\pi/8/1 + \sqrt{2}$).

2. Modulation process according to claim 1, characterised thereby, that the mixing of the carrier signals (S1 to S3) with the modulation signal (L) takes place with the use of the switch method.

3. Arrangement for the performance of the process according to one of the claims 1 to 3, characterised thereby,

- that a respective mixer (MI1 to MI3) is provided for the mixing of each of the phase-displaced carrier signals (S1 to S3) with the modulation signal (L) and an addition member (SUM) is provided for the addition of the mixture signals (M1 to M3),
- that the first mixer (MI1) fed with the first carrier signal (S1) and the third mixer (MI3) fed with the third carrier signal (S3) are each connected with the addition member (SUM) by way of a resistor (R1; R3) weighting the first and third mixture signals (M1; M3) by the factor $1/\sqrt{2}$ and the second mixer (MI2) fed with the second carrier signal (S2) is connected directly with the addition member (SUM),
- that the modulation signal (L) is fed to the addition member (SUM) by way of a weighting resistor (R2) connected in parallel with the mixers (MI1 to MI3) and that this resistor (R2) is dimensioned in such a manner that the carrier-borne components of the sum of the mixture signals (M1 to M3) are acted on by a factor $\pi/8\ (1\ +\ \sqrt{2})$.

4. Arrangement according to claim 3 for the production of an MPX signal for stereo radio with two different modulation signals, characterised thereby,

- that the three mixers (MI1 to MI3) are each split up respectively into a first partial mixer (MIL1, MIL2, MIL3) and a second partial mixer (MIR1, MIR2, MIR3),
- that the first partial mixers (MIL1 to MIL3) mix the first modulation signal (L) with a first group of carrier signals (S1 to S3), which are displaced in phase one relative to the other by -45°, 0° and +45°, and the second partial mixers MIR1 to MIR3) mix the second modulation signal (R) with a second group of carrier signals (S1′ to S3′), which are displaced in phase one relative to the other by 180°-45°, 0° and 180°+45° and which operate in phase opposition to the first group of carrier signals (S1 to S3).

5. Arrangement according to claim 4, characterised thereby, that for the production of both groups of carrier signals (S1 to S3, S1′ to S3′),
   - a decimal decoder (DEC) is connected by its output 1 with the pulse input CL of a first flip-flop (FF1), by its input 3 with the pulse input C2 of a second flip-flop (FF2), by its output 4 by way of a 1:2 frequency divider (FT) with the data input D2 of the second flip-flop (FF2) and by its output 5 with the pulse input 3 of a third flip-flop (FF3),
   - the second flip-flop (FF2) is connected by its output $\overline{Q2}$ with the data input D1 of the first flip-flop (FF1) and by its output Q2 with the data input D3 of the third flip-flop (FF3),
   - the output 8 in the case of the decimal decoder (DEC) is connected directly with the RESET input MR and the SET and RESET inputs in the case of the three flip-flops (FF1 to FF3) are connected to ground and
   - a pulse signal $f'_T$ of n times the frequency of the carrier signals (S1 to S3, S1′ to S3′) which are displaced in phase one relative to the other by either -45°, 0° and +45° or 180°-45°, 0° and 180° +45° and delivered at the outputs $\overline{Q1}$, $\overline{Q2}$ and $\overline{Q3}$ or Q1, Q2 and Q3 of the three flip-flops (FF1 to FF3) is present at the pulse input CL of the decimal decoder (DEC).

**Revendications**

1. Procédé de modulation selon lequel des signaux de porteuse mutuellement déphasés sont générés d'abord, ces signaux de porteuse déphasés (S1 à S3) sont ensuite mélangés, séparément l'un de l'autre, avec un signal de modulation (L) et les produits de mélange sont pondérés et additionnés enfin en vue de l'obtention du signal de porteuse modulé, caractérisé en ce que trois signaux de porteuse (S1 à S3) mutuellement déphasés sont générés, que la phase du premier signal de porteuse (S1) est décalée de - 45° ou de tout au moins à peu près - 45° par rapport à la phase, définie par 0°, du deuxième signal de porteuse (S2) et la phase du troisième signal de porteuse (S3) est décalée de + 45° ou tout au moins d'à peu près + 45° par rapport à la phase du deuxième signal de porteuse (S2), que les premiers signaux de mélange (M1), générés par le mélange du premier signal de porteuse (S1) et du signal de modulation (L), de même que les troisièmes signaux de mélange (M3), générés par le mélange du troisième signal de porteuse (S3) et du signal de modulation (L), sont pondérés chacun d'un premier facteur $1/\sqrt{2}$, et que la somme des signaux de mélange (M1 à M3) est ajoutée au signal de modulation (L), pondéré d'un deuxième facteur, de manière que les composantes pourvues de porteuse de la somme des signaux de mélange (M1 à M3) soient affectées d'un facteur $\pi/8$ 1 + $\sqrt{2}$).

2. Procédé de modulation selon la revendication 1, caractérisé en ce que le mélange des signaux de porteuse (S1 à S3) et du signal de modulation (L) s'effectue avec application du procédé à interrupteurs.

3. Montage pour la mise en oeuvre du procédé selon la revendication 1 ou 2, caractérisé en ce que
   - pour mélanger les signaux de porteuse déphasés (S1 à S3) avec le signal de modulation (L), on a prévu chaque fois un mélangeur (MI1 à MI3) et, pour additionner les signaux de mélange (M1 à M3), on a prévu un additionneur (SUM);
   - le premier mélangeur (MI1), recevant le premier signal de porteuse (S1), et le troisième mélangeur (MI3), recevant le troisième signal de porteuse (S3), sont reliés chacun à l'additionneur (SUM) à travers une résistance (R1; R3) affectant les premier et troisième signaux de mélange (M1; M3) respectivement d'un premier facteur de pondération $1/\sqrt{2}$, et le deuxième mélangeur (MI2), recevant le deuxième signal de porteuse (2), est relié directement à l'additionneur (SUM);
   - le signal de modulation (L) est appliqué à l'additionneur (SUM) à travers une résistance de pondération (R2) monté en parallèle avec les mélangeurs (MI1 à MI3), et que cette résistance (R2) est dimensionnée de manière que les composantes pourvues de porteuse de la somme des signaux de mélange (M1 à M3) soient affectées du facteur $\pi/8$ (1 + $\sqrt{2}$).

4. Montage selon la revendication 3 pour générer un signal multiplexé pour la radiodiffusion stéréophonique à l'aide de deux signaux de modulation différents, caractérisé en ce que
   - les trois mélangeurs (MI1 à MI3) sont divisés chacun en un premier et un second mélangeur partiel (MIL1, MIR1; MIL2, MIR2; MIL3, MIR3);

7

- les premiers mélangeurs partiels (MIL1 à MIL3) mélangent le premier signal de modulation (L) avec un premier groupe de signaux de porteuse (S1 à S3) mutuellement déphasés de respectivement - 45°, 0° et + 45° et les seconds mélangeurs partiels (MIR1 à MIR3) mélangent le second signal de modulation (R) avec un second groupe de signaux de porteuse (S1' à S3') mutuellement déphasés de respectivement 180° - 45°, 180° et 180° + 45° et agissant en alternance avec le premier groupe de signaux de porteuse (S1 à S3).

5. Montage selon la revendication 4, caractérisé en ce que, pour la génération des deux groupes de signaux de porteuse déphasés (S1 à S3; S1' à S3')
   - un décodeur décimal (DEC) est relié par sa sortie 1 à l'entrée d'horloge CL d'une première bascule (FF1), par sa sortie 3 à l'entrée d'horloge C2 d'une deuxième bascule (FF2), par sa sortie 4 à travers un diviseur de fréquence 1:2 (FT) à l'entrée de données D2 de la deuxième bascule (FF2) et par sa sortie 5 à l'entrée d'horloge C3 d'une troisième bascule (FF3);
   - la deuxième bascule (FF2) est reliée par sa sortie $\overline{Q}2$ à l'entrée de données D1 de la première bascule (FF1) et par sa sortie Q2 à l'entrée de données D3 de la troisième bascule (FF3);
   - la sortie 8 du décodeur décimal (DEC) est reliee directement à l'entrée de remise à zéro MR de ce décodeur et les entrées de mise à 1 et de remise à zéro des trois bascules (FF1 à FF3) sont reliées à la masse; et
   - à l'entrée d'horloge CL du décodeur décimal (DEC) est appliqué un signal d'horloge $f'_T$ ayant une fréquence correspondant à n fois la fréquence des signaux de porteuse (S1 à S3; S3' à S1') délivrés aux sorties $\overline{Q1}$, $\overline{Q2}$, $\overline{Q3}$ respectivement Q1, Q2, Q3 des trois bascules (FF1 à FF3) et mutuellement déphasés de - 45°, 0° et + 45° respectivement 180° + 45°, 180° et 180° - 45°.

FIG. 1

FIG. 2

FIG. 3

FIG. 4

CL

MR,8

1

3

4

5

I. AT,D2

Q2 D3

Q3

$-45°$ $+45°$

Q1

II. AT,D2

Q2,D3

Q3

$-45°$ $+45°$

Q1

"‒ ‒ ‒ ‒" <⇒ nicht definierter Zustand

t

FIG. 5